# EUROPEAN PATENT APPLICATION

(11) **EP 1 498 842 A1**
(43) Date of publication of application: **19.01.2005**
(21) Application number: 03715472.1
(22) Date of filing: 27.03.2003
(51) Int. Cl.: G06K 19/077, H01Q 1/24, H01Q 1/38, H01L 25/00

(54) **COMMUNICATION DEVICE AND PACKAGE THEREOF**

(30) Priority: 01.04.2002 JP 2002098909
(71) Applicant: K-Ubique ID Corporation, Tokyo 161-0033 (JP)
(72) Inventor: TAKAYAMA, Toshiharu, Kamiinagun, Nagano 399-4601 (JP)
(74) Representative: Skone James, Robert Edmund
(86) International application number: PCT/JP2003/003790
(87) International publication number: WO 2003/083770

(57) **Abstract**

A communication device capable of eliminating complexity of mounting a RFID part (1) onto a commodity such as an electronic device. For this, the RFID part (1) is fixed on an insulation substrate (2) and the insulation substrate (2) can be mounted on the surface of a circuit plate. Thus, the RFID part (1) can be mounted onto a commodity by the technique of mounting on the general-purpose circuit plate. This significantly reduces the mounting work and achieves the object of the invention. The communication device may be such that the RFID part (1) is fixed on a surface-mounted chip antenna (5) and the RFID part (1) has an antenna terminal (13) electrically connected to a terminal of the surface-mounted chip antenna (5).

## Description

### TECHNICAL FIELD

The present invention relates to a communication device and package thereof. The communication device uses a RFID part and is particularly placed on an electronic device.

### BACKGROUND ART

In recent years, product development and consideration have been proceeded for the communication device that uses a RFID (Radio Frequency Identification) technology. Such the communication device is capable of serving as an alternative to conventional bar codes, containing (storing) a large amount of information, easy and relatively distant information reading in non-contact with an information reader named scanner, and writing information into the RFID part. Accordingly, its applications to various uses are expected.

The above uses include its attachment to a courier parcel to easily trace the parcel delivery, and individual management of massive various commodities in music CD stores and bookstores. The attachment is usually achieved by sticking a resinous film having the RFID part fixedly attached thereon.

The attachment is complicated because it is usually achieved on an individual commodity basis with the manual work.

A subject to be solved in the present invention is to eliminate such the complexity.

### DISCLOSURE OF THE INVENTION

To solve the above subject, a first communication device of the present invention comprises a RFID part 1 fixed on an insulation substrate 2. The insulation substrate 2 is surface-mountable on a circuit board. The communication device of the present invention is premised on attachment to a commodity provided with a circuit board that receives various electronic components surface-mounted thereon. Specific examples of such the commodity include small electronic devices such a mobile phone, a portable personal computer and a head phone stereo.

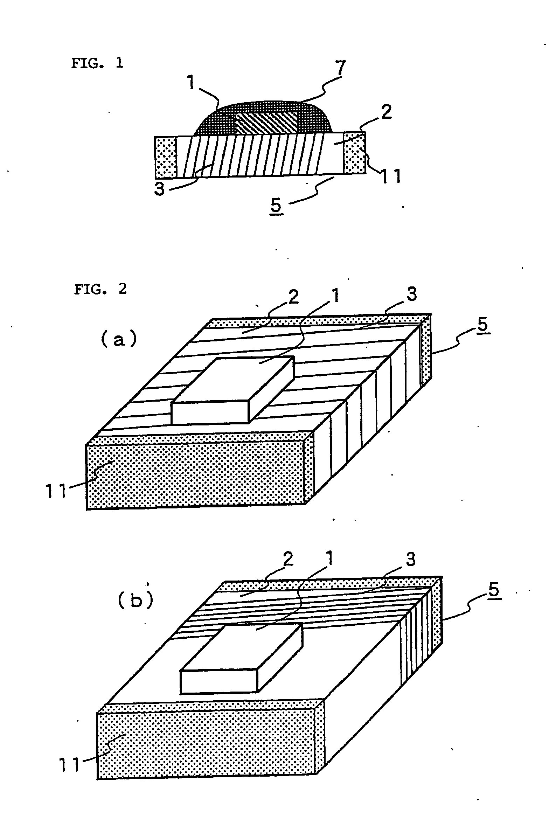

The first communication device has almost the same appearance as that of an existing chip component as shown in Fig. 1, for example. Accordingly, the RFID part 1 can be attached to a commodity using a general-purpose mounting technology and mounting machine. As a result, the load on attachment work can be reduced greatly to allow the subject to be solved in the present invention.

The general-purpose mounting technology is employed to fixedly attach the communication device of the present invention to the circuit board with the use of a fixedly attaching material such as cream solder and an adhesive. When the cream solder is used, similar to the material for fixedly attaching other electronic components to the circuit board, the cream solder is supplied onto the circuit board by screen printing with a metal mask at the same time. Then, the general-purpose mounting machine is employed to position and mount each electronic component (including the communication device of the present invention) on the cream solder. Then, passing through a publicly known reflow furnace, the cream solder is molten and solidified to fixedly attach the communication device of the present invention to the circuit board.

When an epoxy adhesive is employed as the material for fixedly attaching the communication device of the present invention to the circuit board, the adhesive is supplied to the circuit board by screen printing or using a dispenser capable of supplying a constant amount of paste. In many cases, the communication device of the present invention may be disposed on the same surface of a circuit board together with other electronic components and then subjected to the reflow step. As a result, application of the screen printing technology may become difficult after mounting other components due to the existence of other components. This is because the screen may contact with projections in the print surfaces of other components to prevent achievement of excellent printings. Implementation of screen-printing targeted only for the communication device of the present invention before mounting other electronic components is not preferable because it increases the number of process steps. Therefore, on condition that the print surfaces have projections due to the existence of other components, the use of the dispenser is preferable.

On passing through the so-called reflow step, other components are once fixed on the circuit board via an adhesive, then immersed into a molten solder bath and fixedly attached to the circuit board. In this case, it is possible by the screen-printing to supply the adhesive for the communication device of the present invention together with the adhesive for other components. In that case, the adhesive can be hardened with heat (200-300 °C) from the molten solder when it is immersed into the molten solder bath.

When the adhesive is employed as the fixedly attaching material, the terminal 11 shown in Figs. 1, 2, 3 and 6 are not always required because the terminal 11 is employed in main consideration of elevating the affinity with the solder and extending the area of a higher affinity portion.

To solve the above subject, a second communication device of the present invention comprises a RFID part 1 fixed on a surface-mount chip antenna 5. An antenna terminal 13 of the RFID part 1 is electrically connected to a terminal of the surface-mount chip antenna 5. Even this configuration allows the subject to be solved in the present invention, needless to say. In addition, the second communication device of the present invention has an advantage in extending the distance communicable from the RFID part 1 because it can achieve an effect almost equal to the effect resulted from the extended antenna.

The terminal of the chip antenna 5 herein described (the antenna terminal 13) is not always coincident with the terminal 11 described above. If the antenna terminal 13 of the RFID part 1 is electrically connected with a conductive wire 3, the terminal 11 is not always required on the side of the chip antenna 5. The surface-mount chip antenna 5 in the second communication device is a coil antenna composed of a helical conductive wire arranged on the cover layer of the upper, lower and side faces of the chip (Fig. 2). Another example is a stacked chip antenna 5, which may be made by screen-printing using a dielectric paste and a conductive paste. Such the stacked chip antenna is advantageously excellent in high heat resistance.

The "fixture" in the first or second communication device is achieved by a technology of resin molding, for example. This technology is suitable for continuous and massive production. The resin is an epoxy resin, for example. The use of a black one as the resin enables white ink to indicate (print) characters and symbols clearly on the resin surface. Application of the screen-printing technology or the inkjet technology can achieve such the indication.

To allow the subject to be solved in the present invention through the use of the general-purpose mounting technology, the first or second communication device is preferably packaged in the so-called taping material or provided in a state packaged in the so-called bulk casing. This is advantageously possible to supply the communication devices to the mounting machine continuously and automatically, thus advantageously reduce the load on the communication device attaching work.

With respect to packaging in the latter bulk casing, the RFID part 1 fixed on the insulation substrate 2 may collide or rub against others in the package container. As a result, it may be often difficult to maintain the fixture. If the terminal of the chip antenna 5 is electrically connected with the antenna terminal 13 of the RFID part 1, the connection may be lost possibly.

Adoption of the fixing means with the molding technology is suitable because the mold material (normally resin) absorbs impacts on collision to reduce the possibility of damaging the communication device of the present invention. It is also possible to keep the electrical connection in a nice condition at the electrically connected portion. In particular, adoption of the wire bonding technology to the electrical connection can prevent disconnection of the wire that is usually very thin and easily breakable.

Preferably, the insulation substrate 2 or the surface-mount chip antenna 5 has a recess 6, and the RFID part 1 is disposed in the recess 6. This enable the communication device of the present invention to have an outer shape approximated to a cubical shape. The approximated cubical outer shape is excellent in handling. In particular, it is excellent in handling on mounting by a general-purpose automatic mounting machine. The mounting by the general-purpose automatic mounting machine passes through the steps of adsorbing one surface of a cube, andholding andmoving the communication device with the adsorbing force. This is effective to limit a location of the RFID part 1 arranged on the insulation substrate 2 or the surface-mount chip antenna 5 within a certain range (the recessed region). As a result, variations in the characteristics and the shape of the communication device of the present invention can be reduced advantageously.

The recess 6 is formed through a process of drilling into the insulation substrate 2, for example. In addition, if two or more insulation substrates are stacked to form the insulation substrate 2 according to the present invention, the insulation substrate in the surface layer may be shaped in the form of a frame that has an opening corresponding to the recess 6. If the insulation substrate 2 is composed of a ceramic, a means for press-molding ceramic component powders thereof may be employed before calcination of the ceramic.

The communication device of the present invention may be mounted on an electronic device or other products completed through multiple process steps to identify, after mounting, the steps through which the electronic device or the like has been produced. A history of process steps associated with the electronic device or the like can be stored in the RFID part 1 of communication device. In this case, communications with a device for writing information into the RFID part 1 are required after completion of necessary steps, for example. The information on such the step history includes information on dates and conditions (a highest temperature in the heating step, for example) made available in respective steps, and names of workers. On inspection of products after completion of all process steps, the information stored in the communication device is read out using a scanner or the like to identify whether it is suitable for shipping, whether the product is expected for shipping, and whether the date of shipping is correct. In this way, various management items can be imposed on the communication device. In case of an occurrence of a malfunction in a product aftershipping, the management item concerned is identified using the scanner or the like to quickly track down the reason for the malfunction to prevent a secondary occurrence of such the malfunction early.

Therefore, all communication devices based on the above first and second communication devices of the present invention are preferably those that are mountable on an electronic device or other products completed through multiple process steps, and the historical information on the steps is stored in the RFID part 1.

### BRIEF DESCRIPTION OF THE DRAWINGS

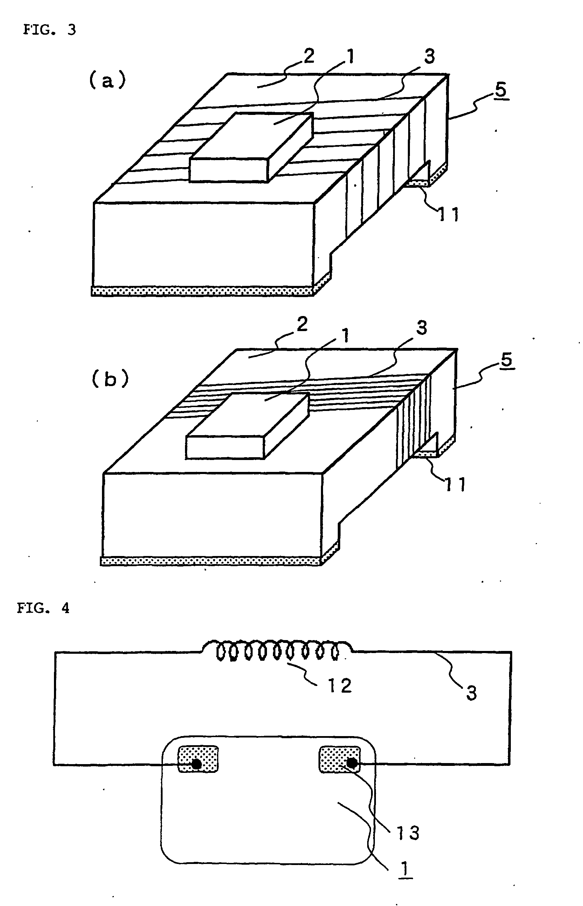

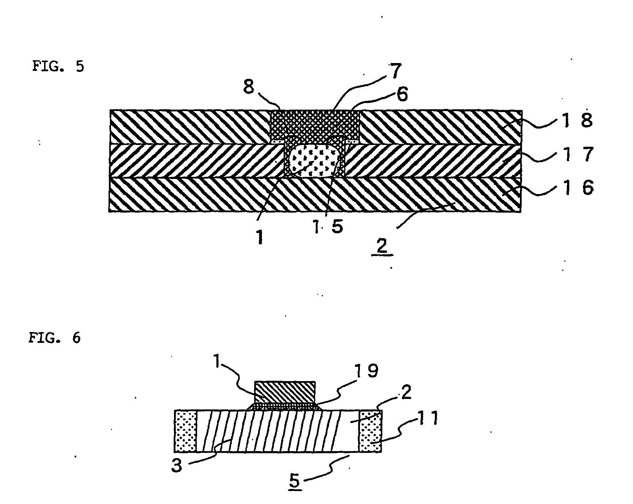

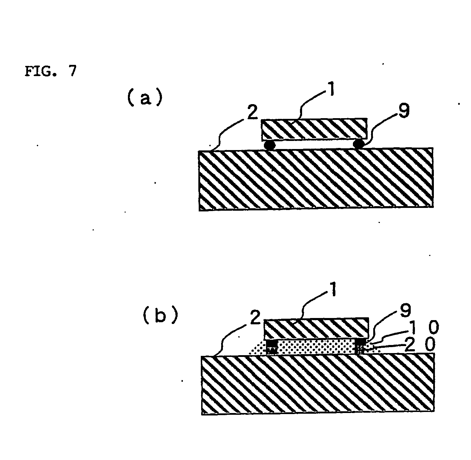

Fig. 1 is a diagram showing an outline of the embodiment of the communication device of the present invention. Fig. 2 is a diagram showing an outline of the embodiment of the communication device of the present invention. Fig. 3 is a diagram showing an outline of the embodiment of the communication device of the present invention. Fig. 4 is a diagram showing an outline of an electrical connection between a RFID part and an antenna in the communication device of the present invention. Fig. 5 is a diagram showing an outline of the embodiment of the communication device of the present invention. Fig. 6 is a diagram showing another example of the outline of the embodiment of the communication device of the present invention. Fig. 7 is a diagram showing yet another example of the outline of the embodiment of the communication device of the present invention.

The reference numerals given in these drawings denote: 1... RFID part, 2... Insulation substrate, 3... Conductive wire, 5... Chip antenna, 6... Recess, 7... Mold resin, 8... Bonding wire, 9... Bump, 10... Anisotropic conductive substance, 11... Terminal, 12... Coiled portion, 13... Antenna terminal, 15... Land, 16... First layer, 17... Second layer, 18... Third layer, 19... Adhesive, and 20... Compressed portion.

### BEST MODE FOR CARRYING OUT THE INVENTION

The embodiments of the present invention will now be described.

The RFID part 1 is commercially available. The RFID part 1 is shaped in a chip with outer sizes of about 1 mm width, depth and height each and has antenna terminals 13 provided at two locations. The insulation substrate 2 is a molding of more than 91% pure alumina. The insulation substrate 2 has a sufficient strength so that it can not be broken when sandwiched in the general-purpose mounting machine. It also has a sufficient insulation property.

In Fig. 2(a), the insulation substrate 2 is shaped in a rectangular solid. The conductive wire 3 is wound around the cover layer of the upper, lower and side faces, that is, the surface of the substrate to configure the chip antenna 5, and the RFID part 1 is mounted thereon. Then, the wire bonding technology is applied to electrically connect the antenna terminal 13 of the RFID part 1 to the conductive wire 3 via a gold wire, not shown. Further, an epoxy resin is employed to fix on the insulation substrate 2 the whole RFID part 1 including the electrically connected portion (Fig. 1). For the fixture, the publicly known resin molding technology is adopted.

Thus, the communication device of the present invention can be produced.

In this embodiment, the insulation substrate 2 is shaped in the rectangular solid as shown in Fig. 2(a) though it is not limited to this shape. For example, as shown in Fig. 3(a), the insulation substrate 2 may have an angled C-shaped side. In this case, the bottom of the insulation substrate 2 is employed to locate the terminal of the chip antenna 5, (the antenna terminal 13). A high-frequency electromagnetic wave transmitted from the scanner is absorbed through the terminal 11 to the earth to generate a magnetic field at the coil composed of the conductive wire 3. The magnetic field is received at the chip antenna 5 and rectified at an IC high-frequency rectifier in the RFID part 1 to generate power. This power is employed to drive an IC microcomputer, modulate an input wave with I/O data stored in an inner memory, and send the I/O data back to the scanner. Thus, the RFID part 1 can operate without a power source mounted as a separate member.

The communication device of the present invention shown in Fig. 3 has a space formed in the lower portion. This space may be employed to previously locate the RFID part 1 therein. This is effective to smooth the upper surface of the communication device of the present invention. As a result, when the general-purpose mounting machine adsorbs the communication device of the present invention to hold and move the component, easy and reliable adsorption can be achieved advantageously. In this example the conductive wire 3 is wound around almost over the entire region of the cover layer of the upper, lower and side faces of the insulation substrate 2 to configure the chip antenna 5 (Fig. 2(a), Fig. 3(a)). Alternatively, the conductive wire 3 maybe located close to one side of the insulation substrate 2 as shown in Fig. 2(b) and Fig. 3(b) to facilitate the work of mounting and fixing the RFID part 1 advantageously. This is because it is more or less difficult to mount and fix the RFID part 1 on the surface of the insulation substrate 2, which is a substantially rough surface due to the existence of the conductive wire 3. In a word, the work of mounting and fixing the RFID part 1 can be achieved while avoiding the conductive wire 3.

Fig. 4 shows the electrical connection between the RFID part 1 and the conductive wire 3 in the communication device of the present invention shown in Figs. 2 and 3. It is found that the conductive wire 3 is looped. As it has a coiled portion 12, namely, it is a coil antenna, the high-frequency electromagnetic wave is received at the coiled portion 12 and rectified at the RFID part 1 to generate power as described above.

An example of the communication device of the present invention is described with reference to Fig. 5. In this example, a recess 6 is formed in the insulation substrate 2, and the chip-shaped RFID part 1 is disposed in the recess 6. Fig. 5 is a vertical cross-sectional view of the communication device. The insulation substrate 2 comprises three layers or first through third layers (16-18). The first layer 16 has no hole formed therein. The second layer 17 and the third layer 18 have respective holes formed therethrough. These layers are stacked to form the recess 6 in the holes. The hole in the third layer 18 is slightly larger than the hole in the second layer 17. A terminal portion is formed on the second layer around the hole and electrically connected to the antenna terminal 13 of the RFID part 1 via a bonding wire 8. An epoxy paste is employed as the mold resin 7 to fill the recess 6.

Production of the communication device shown in Fig. 5 is described in detail. First, the first layer 16 and the second layer 17 each composed of an epoxy plate mixed with glass fibers are stacked and integrated. This integration is achieved by thermally crimping both. Next, the chip-shaped RFID part 1 is inserted into a portion that corresponds to the recess 6 in the second layer 17. In this case, the antenna terminal 13 of the RFID part 1 is faced up. The upper surface of the first layer 16 is temporarily fixed to the lower surface of the RFID part 1 via an adhesive, not shown. Then, the publicly known wire bonding technology is applied to electrically connect a land 15 on the upper surface of the second layer 17 to the antenna terminal 13 via the gold bonding wire 8. The electrical connection with the antenna is as shown in Fig. 4. Preferably, the land 15 locates almost the same height as the antenna terminal 13 as shown. This is because the general-purpose wire bonding technology can be utilized almost as it is, and the wire bonding machine can operate without uselessness. Thereafter, the third layer 18 and the second layer 17 in the insulation substrate 2 are stacked and integrated. The third layer 18 is also composed of the same material as those of the first layer 16 and the second layer 17. The stack and integration are similarly implemented as the stack and integration of the first layer 16 and the second layer 16. It is required for the third layer 18 not to damage the bonding wire 8. Then, the epoxy paste (mold resin 7) is filled in the recessed portion 6 and thermally hardened to complete the communication device of the present invention.

Fig. 6 shows a communication device of the present invention according to yet another embodiment. This embodiment is analogous to Fig. 1 except for the following. In the embodiment of Fig. 1 the RFID part 1 is entirely covered in the mold resin 7 and fixed. To the contrary, in the embodiment of Fig. 6 the lower surface of the RFID part 1 is fixed to the upper surface of the chip antenna 5 via an adhesive 19 of the same material as the mold resin 7 used in Fig. 1. Even such the means can achieve the communication device of the present invention.

In all the above embodiments the wire bonding technology is applied to electrically connect the RFID part 1 with the chip antenna 5. Alternatively, flip chip mounting may be employed. Fig. 7 (a) shows an example of such the state. Bumps 9 are formed or disposed on the lower surface of the RFID part 1 and/or the upper surface of the chip antenna 5. The bumps 9 are molten and solidified, otherwise solder is molten and solidified as a separate member, to electrically connect and fixedly attach the RFID part 1 with the chip antenna 5.

In the state shown in Fig. 7(b), the bumps 9 are formed or disposed on the lower surface of the RFID part 1 or the upper surface of the chip antenna 5'. An anisotropic conductive substance 10 in the form of a paste (for example, "TAP/TNP Series" available from Toshiba Chemical Inc.) is employed to fix the RFID part 1 on the chip antenna 5. When the paste is half-hardened by heating, the portion of the paste between the RFID part 1 and the chip antenna 5 is compressed under pressure. As a result, the portion derived from the protruded shape of the bump 9 is compressed particularly to become a rich conductive region, turning other portions in relatively poor conductive regions. (Fig. 7(b) depicts the compressed portion 20 with dense dots). If an anisotropic conductive substance 10 in the form of a sheet is employed instead of the paste, the anisotropic conductive substance 10 is compressed between the bump 9 and the chip antenna 5. In this state, spaces are sealed with a resin or the like (not shown) to fixedly attach the bump 9 to the chip antenna 5 while remaining the state. The compressed portion 20 becomes a rich conductive region and other portions are turned in relatively poor conductive regions. The existence of the poor conductive regions avoids conduction (short-circuit) between adjoining bumps 9.

Preferably, the anisotropic conductive substance 10 in the form of the paste can serve as an adhesive because it has no such inferiority in handling like solder that the solid can not flow unless it is heated and molten. Mounting with the use of the anisotropic conductive substance 10 can reduce the distance between the bumps 9 compared to mounting with the use of solder because there is no member (for example, cream) that provably makes adjoining bumps 9 conductive with each other.

### INDUSTRIAL APPLICABILITY

As described above, the present invention provides a communication device capable of eliminating the complexity associated with the work of attaching the RFID part to a commodity such as an electronic device. An electronic device with the communication device of the present invention mounted thereon is possible to store in the communication device a history of process steps associated with the electronic device.

## Claims

1. A communication device comprising a RFID part fixed on an insulation substrate, wherein said insulation substrate is surface-mountable on a circuit board.

2. A communication device comprising a RFID part fixed on a surface-mount chip antenna, wherein an antenna terminal of said RFID part is electrically connected to a terminal of said surface-mount chip antenna.

3. The communication device according to claim 2, wherein said surface-mount chip antenna is a coil antenna.

4. The communication device according to any one of claims 1-3, wherein fixture is achieved by resin molding.

5. The communication device according to any one of claims 2-4, wherein electrical connection is achieved by wire bonding or flip-chip mounting.

6. The communication device according to any one of claims 1-5, said insulation substrate or said surface-mount chip antenna having a recess, wherein said RFID part is disposed in said recess.

7. The communication device according to any one of claims 1-7, wherein said communication device is a communication device placed on an electronic device or other products completed throughmultiple process steps, saidRFIDpart storing historical information about said process steps.

8. A communication device package comprising a taping material or a bulk casing configured to package said communication device according to any one of claims 1-7.
